# EUROPEAN PATENT APPLICATION

(11) **EP 4 538 610 A1**
(43) Date of publication of application: **16.04.2025**
(21) Application number: 23819115.9
(22) Date of filing: 06.06.2023
(51) Int. Cl.: F24F 11/89

(54) **AIR CONDITIONER INDOOR UNIT**

(30) Priority: 06.06.2022 CN 202210634576; 06.06.2022 CN 202221411290 U; 06.06.2022 CN 202221406073 U
(71) Applicant: GD Midea Heating & Ventilating Equipment Co., Ltd., Foshan, Guangdong 528311 (CN); Hefei Midea Heating & Ventilating Equipment Co., Ltd, Hefei, Anhui 230601 (CN)
(72) Inventor: GU, Yong, Foshan, Guangdong 528311 (CN); FENG, Zhengbo, Foshan, Guangdong 528311 (CN); LI, Yunzhi, Foshan, Guangdong 528311 (CN); KAN, Changli, Foshan, Guangdong 528311 (CN); TANG, Changqing, Foshan, Guangdong 528311 (CN); ZHU, Menghao, Foshan, Guangdong 528311 (CN); MA, Mingtao, Foshan, Guangdong 528311 (CN); WU, Lin, Foshan, Guangdong 528311 (CN); ZHOU, Baisong, Foshan, Guangdong 528311 (CN)
(74) Representative: Haseltine Lake Kempner LLP
(86) International application number: PCT/CN2023/098608
(87) International publication number: WO 2023/236950

(57) **Abstract**

Provided is an air conditioner indoor unit (100) including a housing (10) and a blower assembly (20). The housing (10) has an air supply duct (101) and an electric control chamber (102). The electric control chamber (102) has a main control module (31) provided therein. The blower assembly (20) includes an electric motor (22), a blower (21), and a drive module (32). The blower (21) is disposed in the air supply duct (101) for driving an airflow. The electric motor (22) is in transmission connection with the fan (21). The drive module (32) is electrically connected to the electric motor (22).

## Description

### CROSS-REFERENCE TO RELATED APPLICATIONS

This application claims priority to Chinese Patent Application No. 202210634576.8, entitled "Air conditioner indoor unit," filed to the China Patent Office on June 06, 2022, the entire contents of which are incorporated herein by reference.

This application claims priority to Chinese Patent Application No. 202221411290.5, entitled "Air conditioner indoor unit," filed to the China Patent Office on June 06, 2022, the entire contents of which are incorporated herein by reference.

This application claims priority to Chinese Patent Application No. 202221406073.7, entitled "Air conditioner indoor unit," filed to the China Patent Office on June 06, 2022, the entire contents of which are incorporated herein by reference.

### TECHNICAL FIELD

The present disclosure relates to the technical field of air conditioning, and in particular, to an air conditioner indoor unit.

### BACKGROUND

In the related air conditioner art, a drive module of a blower is typically integrated into the blower. The blower is connected to a main control module by a control harness and a power supply harness. A control signal and the power supply line of the blower are not conducive to the control of the drive module as well as maintenance of the control module.

### SUMMARY

The present disclosure is directed to solve at least one of the technical problems in the related art. To this end, an object of the present disclosure is to provide an air conditioner indoor unit in which a drive module is mounted to a main control module, thereby improving integration level of the control module and facilitating control and the maintenance of a blower.

An air conditioner indoor unit according to at least one embodiment of the present disclosure includes a housing and a blower assembly. The housing has an air supply duct and an electric control chamber provided therein. The electric control chamber has a main control module provided therein. The blower assembly includes an electric motor, a blower, and a drive module. The blower is disposed in the air supply duct for driving airflow. The electric motor is in transmission connection with the blower. The drive module is electrically connected to the electric motor.

In some embodiments of the present disclosure, the drive module is disposed in the electric control chamber. The main control module is separated from the drive module. The drive module is mounted at the main control module.

In some embodiments of the present disclosure, the drive module is disposed at the main control module vertically, or the drive module and the main control module are parallel to each other, or the drive module is inclined relative to the main control module at a predetermined angle.

In some embodiments of the present disclosure, the drive module is disposed in the electric control chamber, and the drive module and the main control module are integrated at one circuit board.

In some embodiments of the present disclosure, the electric control chamber has vents.

In some embodiments of the present disclosure, at least one of the vents is closer to the drive module than the main control module.

In some embodiments of the present disclosure, the drive module is mounted at a corner of the circuit board.

In some embodiments of the present disclosure, the drive module has a radiator provided at a side of the drive module facing towards an outer side of the main control module.

In some embodiments of the present disclosure, the drive module has a module pin, and the drive module is connected to the main control module by the module pin.

In some embodiments of the present disclosure, the module pin is provided with a foil.

In some embodiments of the present disclosure, the module pin has a step structure. The module pin has an end inserted on a main control module of the main control module. A step surface of the module pin is supported at the main control module.

In some embodiments of the present disclosure, high heating elements in the main control module and the drive module are disposed at one side of the circuit board, and low heating elements in the main control module and the drive module are disposed on another side of the circuit board.

In some embodiments of the present disclosure, the air conditioner indoor unit further includes a radiator connected to the circuit board. The radiator is disposed inside the electric control chamber or at least partially disposed outside the electric control chamber.

In some embodiments of the present disclosure, the radiator is spaced apart from the circuit board. The air conditioner indoor unit further includes an insulation support connected to the circuit board and the radiator, respectively.

In some embodiments of the present disclosure, the radiator is disposed in the electric control chamber. The electric control chamber has a vent formed at a wall of the electric control chamber, and the vent faces towards a fin gap of the radiator.

In some embodiments of the present disclosure, the drive module is disposed horizontally. The drive module has a drive chip provided at an upper part of the drive module. The radiator is disposed above the drive chip and covers the drive chip.

In some embodiments of the present disclosure, the radiator at least partially extends out of the electric control chamber towards the air supply duct and extends into the air supply duct.

In some embodiments of the present disclosure, the radiator at least partially extends out of the electric control chamber away from the air supply duct.

In some embodiments of the present disclosure, the radiator is parallel or perpendicular to the circuit board, or an angle formed between the radiator and the circuit board is smaller than 90.

In some embodiments of the present disclosure, the radiator completely covers the drive chip of the drive module. The radiator has a peripheral edge extending beyond the drive chip, an air gap is formed between the peripheral edge of the radiator and the drive module.

In some embodiments of the present disclosure, the drive module is disposed in the housing. The drive module includes a drive board and a cover body. The drive board is electrically connected to the blower assembly, and the cover body is disposed outside the drive board.

In some embodiments of the present disclosure, the cover body is provided with a first positioning portion, and the drive board is provided with a second positioning portion. The second positioning portion cooperates with the first positioning portion to restrict the cover body from being disengaged from the drive board.

In some embodiments of the present disclosure, one of the first positioning portion and the second positioning portion includes a positioning hook, and another one of the first positioning portion and the second positioning portion includes a positioning recess.

In some embodiments of the present disclosure, the cover body has an accommodation recess. The drive board is embedded into the accommodation recess. The first positioning portion is disposed at at least one of two opposite side surfaces of the accommodation recess. The second positioning portion is disposed on the drive board and corresponds to the first positioning portion.

In some embodiments of the present disclosure, the cover body has an accommodation recess. The drive board is embedded into the accommodation recess. The drive board has a sliding groove formed at two opposite surfaces of the accommodation recess and allowing a side edge of the drive board to slid into the accommodation recess.

In some embodiments of the present disclosure, a gap is formed between the cover body and the drive board. The cover body has a heat dissipation hole in communication with the gap.

In some embodiments of the present disclosure, the drive module further includes a radiator connected to the drive board and configured to exchange heat with the drive board. The drive board is interposed between the radiator and the cover body.

In some embodiments of the present disclosure, the cover body includes a first plate portion and a second plate portion. The first plate portion and the radiator are disposed at two opposite sides of the drive board. The second plate portion is connected to the first plate portion and covers the radiator and a gap between the radiator and the first plate portion.

In some embodiments of the present disclosure, the radiator is connected to the drive board and configured to exchange heat with the drive board. The drive board is provided with a fin at a side of the radiator facing away from the drive board.

In some embodiments of the present disclosure, the drive board is disposed in the air supply duct.

In some embodiments of the present disclosure, the housing further has an electric control chamber provided therein. The drive board is disposed in the electric control chamber.

In some embodiments of the present disclosure, the electric control chamber further has a main control panel provided therein. The drive board is mounted at the main control panel.

### BRIEF DESCRIPTION OF DRAWINGS

In order to more clearly describe the technical solutions in at least one embodiment of the present disclosure or the related art, drawings to be used in the description of at least one embodiment or the related art will be briefly introduced below. It will be apparent to those skilled in the art that the drawings in the following description are merely at least one embodiment of the present disclosure of the invention, and other drawings may be obtained from the structure shown in the drawings without any creative steps.
FIG. 1 is a schematic view of an air conditioner indoor unit according to at least one embodiment of the present disclosure.
FIG. 2 is a schematic view of an electric control chamber according to at least one embodiment of the present disclosure, in which a state where a drive module is disposed to a main control module vertically is shown.
FIG. 3 is a cross-sectional view of an electric control chamber according to at least one embodiment of the present disclosure, in which a state where a drive module is disposed at a main control module vertically is shown.
FIG. 4 is a schematic view of an air conditioner indoor unit according to at least one embodiment of the present disclosure;
FIG. 5 is a schematic view of a circuit board according to at least one embodiment of the present disclosure;
FIG. 6 is a schematic view of a circuit board according to further embodiments of the present disclosure;
FIG. 7 is a schematic view of a radiator according to yet further embodiments of the present disclosure;
FIG. 8 is a schematic partial structural view of an air conditioner indoor unit according to yet further embodiments of the present disclosure.
FIG. 9 is a schematic view of an air conditioner indoor unit according to at least one embodiment of the present disclosure.
FIG. 10 is a schematic view of an air conditioner indoor unit according to at least one embodiment of the present disclosure.
FIG. 11 is a schematic view of an electric control chamber of an air conditioner indoor unit according to at least one embodiment of the present disclosure.
FIG. 12 is a top view of FIG. 11;
FIG. 13 is a sectional view through along a line A-A in FIG. 12.

Reference numerals:
air conditioner indoor unit 100; housing 10; electric control box 11 11; air supply duct 101; electric control chamber 102; first positioning portion 103, second positioning portion 104, heat dissipation hole 105 and vent 110; blower assembly 20; blower 21; electric motor 22; circuit board 30; main control module 31; drive module 32; drive board 111, cover body 112, first plate portion 1121, second plate portion 1122, and drive chip 321; connector 322; radiator 33; main body portion 331; fin 332; insulation support 34; pin 35.

The objects, features, and advantages of the present disclosure will be further described in connection with at least one embodiment with reference to the accompanying drawings.

### DESCRIPTION OF EMBODIMENTS

Reference will now be made in detail to at least one embodiment of the present disclosure, examples of which are illustrated in the accompanying drawings, wherein like reference numerals refer to the same or similar elements throughout the several views, and or refer to having the same or similar elements throughout the several views. The at least one embodiment described below by reference to the drawings are exemplary, and they are intended to be illustrative of the present disclosure and are not to be construed as limiting the present disclosure.

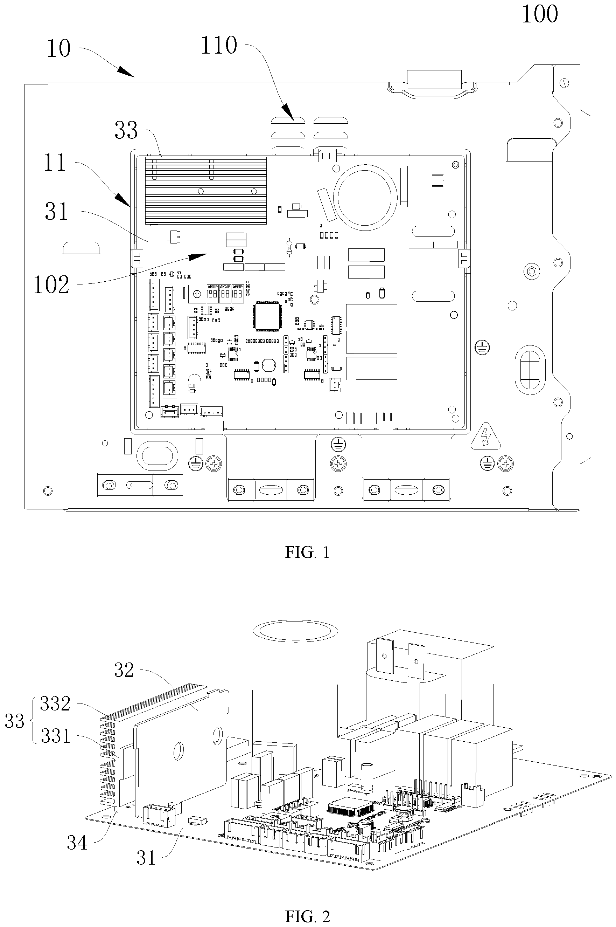

Referring to FIG. 1 to FIG. 13, an air conditioner indoor unit 100 according to at least one embodiment of the present disclosure includes a housing 10 and a blower assembly 20. The housing 10 has an air supply duct 101 and an electric control chamber 102 provided therein. The electric control chamber 102 has a main control module 31 provided therein. The blower assembly 20 includes an electric motor 22, a blower 21, and a drive module 32. The blower 21 is disposed in the air supply duct 101 for driving airflow. The electric motor 22 is in transmission connection with the blower 21. The drive module 32 is electrically connected to the electric motor 22. The drive module 32 is configured to drive the electric motor 22 to operate, which in turn drives the blower 21. In other words, the drive module 32 can control the electric motor 22 to rotate, and the electric motor 22 can drive the blower 21 to operate. The drive module 32 is disposed in the electric control chamber 102. The main control module 31 and the drive module 32 are separate members, and the drive module 32 is mounted at the main control module 31. That is, the drive module 32 may be disposed in the electric control chamber 102, which facilitates an integrated control of the air conditioner indoor unit 100 and an optimization of an internal space arrangement, thereby saving space. Further, since the drive module 32 is mounted at the main control module 31, the main control module 31 can easily control the drive module 32, thereby better controlling an operation condition of the blower 21.

It should be noted that the electric control chamber 102 may be spaced apart from the air supply duct 101. That is, the electric control chamber 102 and the air supply duct 101 may define two chambers. The two chambers may be partially separated from each other. For example, there may be a vent or a ventilation channel between the two chambers to allow the airflow in the air supply duct 101 flow through the electric control chamber 102, thereby exchanging heat with the electric control chamber 102. In other embodiments, the electric control chamber 102 may also be spaced apart from the air supply duct 101 in one chamber.

In addition, generally, a heat generating amount of the drive module 32 is greater than that of the main control module 31. Therefore, the main control module 31 and the drive module 32 are designed separate members to avoid signal interference or mutual influence between the main control module 31and the drive module 32, thereby improving stability and reliability of the operation.

In the air conditioner indoor unit 100 according to at least one embodiment of the present disclosure, by mounting the drive module 32 at the main control module 31, the integration of the air conditioner indoor unit 100 can be realized, and the control can be facilitated. During the assembly, the main control module 31 and the drive module 32 are first assembled together, and then the assembled main control module 31 and drive module 32 are mounted at a corresponding position on the air conditioner indoor unit 100. In this way, modularization effect of the air conditioner indoor unit 100 is improved. In addition, signal transmission between the main control module 31 and the drive module 32 is facilitated, which facilitates the control on the blower 21 and meet more complicated driving requirements of the blower 21.

In at least one embodiment of the present disclosure, the air conditioner indoor unit 100 may further include a heat exchanger disposed in the housing. In this way, heat exchange effect of the air conditioner indoor unit 100 can be improved.

In at least one embodiment of the present disclosure, the drive module 32 may not be mounted at the main control module 31. That is, the drive module 13 and the main control module 31 may be separately arranged in the electric control chamber 102. In this way, an integrated control on the air conditioner indoor unit 100 can be realized, and the stability of operation can be improved.

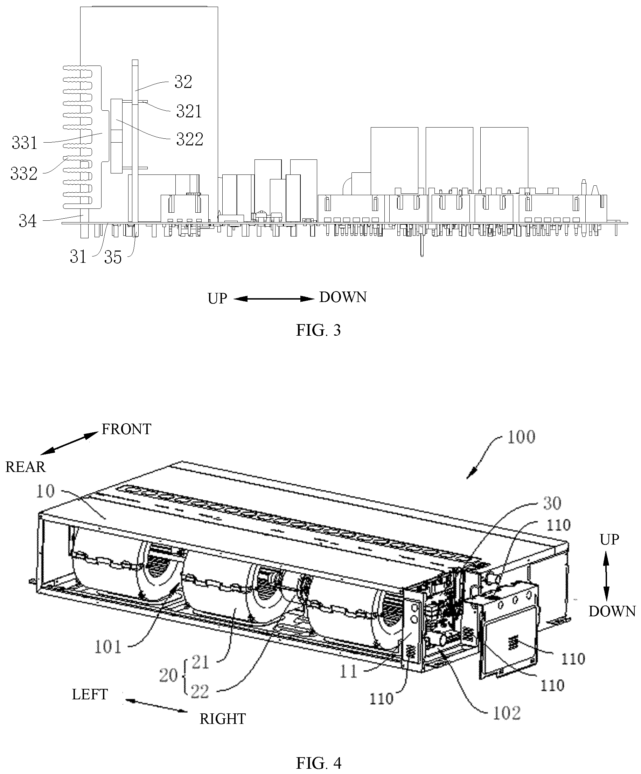

In conjunction with FIG. 2 and FIG. 3, in at least one embodiment of the present disclosure, the drive module 32 is disposed at the main control module 31 vertically. In this way, a plane space of the main control module 31 can be effectively saved, thereby facilitating the space arrangement.

In at least one embodiment of the present disclosure, the drive module 32 may also be parallel to the main control module 31. In other embodiments, it is also possible that the drive module 32 is inclined relative to the main control module 31 at a predetermined angle. In practice, the arrangement may be designed based on a specific structure of the air conditioner indoor unit 100 or the electric control chamber 102, and the present disclosure is not limited in this regard.

In an exemplary embodiment of the present disclosure, the drive module 32 and the main control module 31 may have different cooperating and positional relationships. The drive module 32 may be disposed at the main control module 31 vertically. In this way, the space occupied by the drive module 32 can be reduced. The main control module 31 typically has an arrangement such as a capacitor with a relatively large volume. By arranging the drive module 32 vertically, the space on the main control board can be fully used, thereby improving the space utilization rate. Therefore, the space occupied by a control module formed by combining the drive module 32 and the main control module 31 can be reduced.

In addition, the drive module 32 and the main control module 31 may also be in parallel with each other. In this case, in a projection perpendicular to the main control module 31, a projection of the drive module 32 may be completely or partially disposed on the main control module 31, or be completely disposed outside the main control module 31. For example, the drive module 32 may be connected to an edge of the main control module 31 to minimize the mutual interference between the main control module 31 and the drive module 32. The drive module 32 and the main control module 31 may also be opposite to each other in a normal direction of the main control module 31. In this way, the space utilization is improved. Meanwhile, signal interference is also reduced and the heat dissipation is facilitated.

In addition, the drive module 32 may also be inclined relative to the main control module 31 at a predetermined angle. In this case, in the projection perpendicular to the main control module 31, the projection of the drive module 32 may be completely or partially disposed on the main control module 31, or completely disposed outside the main control module 31. For example, the drive module 32 may be connected to the edge of the main control module 31, and extend obliquely away from the main control module 31 or in an opposite direction to the normal direction of the main control module 31. Through the inclined arrangement of the drive module 32, the connection between the drive module 32 and the main control module 31 is facilitated. Further, the inclined arrangement can reduce the distance between the drive module 32 and the main control module 31. Therefore, the assembly and maintenance of the control module can be facilitated. Meanwhile, signal interference can be reduced, the heat dissipation can be facilitated.

Referring to FIG. 2, in at least one embodiment of the present disclosure, the drive module 32 is mounted at a corner portion of the main control module 31. In this way, heat dissipation from the drive module 32 is facilitated. Further, interference of the drive module 32 with other components on the main control module 31 can be avoided.

In conjunction with the foregoing, when the drive module 32 and the main control module 31 are integrated at one circuit board, electronic components of the drive module 32 may be integrated at the circuit board of the main control module 31 near an edge thereof. Likewise, when the drive module 32 and the main control module 31 are separate members, the drive module 32 may be mounted at the circuit board of the main control module 31 near the edge thereof. In other embodiments, it is also possible to mount the drive module 32 at the corner position of the main control module 31 in other manners. In this way, heat dissipation of the drive module 32 can be facilitated, and interference of the drive module 32 with other components at the main control module 31 can be avoided. By connecting the drive module 32 and the main control module 31, with such a reasonable arrangement, a better heat dissipation effect can be provided while saving the space. Further, the drive module 32 and the main control module 31 are mounted and fixed by means of a specific structure, and thus the overall structure is stable and reliable.

In the air conditioner indoor unit 100 of at least one embodiment of the present disclosure, by integrating the drive module 32 and the main control module 31 at one circuit board, the operation efficiency of the control module can be improved, and rapid and stable control on the blower 21 can be realized. For example, a rotational speed can be rapidly adjusted based on control instructions to achieve a constant volume of the air supply. In addition, the assembly and maintenance efficiency of the air conditioner indoor unit 100 can also be improved.

The corner position of the main control module 31 may be disposed on the main control module 31 near the edge of the main control module 31. When the main control module 31 has several edges and a predetermined angle is formed between these edges, a region defined by two or more similar edges may be determined as a corner of the main control module 31. For example, the main control module 31 may be constructed into a rectangular shape. In this case, four corners of the main control module 31 are defined as the corner positions of the main control module 31. Likewise, when the main control module 31 is constructed into a triangular, pentagonal, and other shapes, each corner of the main control module 31 is defined as the corner position of the main control module 31. In addition, the main control module 31 may be constructed into a circular, oval, or other shape. In this case, likewise, a region of the main control module 31 adjacent to the edge thereof may be regarded as the corner position of the main control module 31.

In at least one embodiment of the present disclosure, the main control module 31 is provided with a radiator 33 at a side of the drive module 32 facing towards the outer side of the main control module 31. The radiator 33 is configured to dissipate heat of the drive module 32. In conjunction with the above, the drive module 32 is perpendicular to the main control module 31 and is disposed at the corner (or edge) of the main control module 31. Therefore, the radiator 33 may face towards an outer side of the main control module 31. That is, the radiator 33 faces towards an outer side of a space between the main control module 31 and the drive module 32. In this way, the heat exchange effect of the radiator 33 can be improved. In addition, the heat of the radiator 33 can be prevented from affecting the main control module 31.

In conjunction with FIG. 3, in at least one embodiment of the present disclosure, the drive module 32 has a module pin 35, and the drive module 32 is connected to the main control module 31 by the module pin 35. Therefore, the separate connection between the drive module 32 and the main control module 31 can be achieved. Meanwhile, the drive module 32 can be controlled easily by the main control module 31, which facilitates the integration and reduces interference and influence between the drive module 32 and the main control module 31.

The drive module 32 may have one or more module pins 35. For example, the drive module 32 may have one pin 35, which can simplify the structure.

**In** at least one embodiment of the present disclosure, a foil may be disposed at the module pin 35. The heat dissipation foil can further enhance the heat dissipation effect, and can avoid overheating at the connection between the drive module 32 and the main control module 31, thereby reducing interference between strong and weak electricity.

**In** at least one embodiment of the present disclosure, the module pin 35 has a step structure, which helps to improve the reliability of the overall structure. **In** an exemplary embodiment, one end of the module pin 35 is inserted on the main control module 31 of the main control module 31. Further, a step surface of the module pin 35 is supported at the main control module 31. **In** this way, it is possible to increase a contact area of the module pin 35 with the main control module 31 when being connected to the main control module 31, thereby improving the structural stability of the connection.

**In** addition, in conjunction with the foregoing description, the drive module 32 and the main control module 31 are separate members. That is, the drive module 32 and the main control module 31 may also be arranged separately in the electric control chamber 102. That is, the drive module 32 and the main control module 31 are arranged at different positions in the electric control chamber 102. **In** this way, the stability and safety of operation can be improved. Further, the signal interference or mutual influence between the drive module 32 and the main control module 31 can be avoided. Therefore, the air conditioner indoor unit 100 can be integrated and easily controlled. As a result, the modularization effect of the air conditioner indoor unit 100 is improved, and the signal transmission between the main control module 31 and the drive module 32 is facilitated. Therefore, the blower 20 of the blower assembly 21 can be easily controlled, and more complex drive requirements of the blower 21 can be satisfied.

The drive module 32 and the main control module 31 are arranged at different positions in one chamber. During the heat dissipation, the heat dissipation may be carried out on the electric control module and the drive module 32 simultaneously. Likewise, the drive module 32 and the main control module 31 may be disposed in different chambers. For example, a plurality of cavities is formed in the electronic control chamber 102 and arranged at intervals for storing the main control module 31 and the drive module 32, respectively.

In at least one embodiment of the present disclosure, the electric control chamber 102 has a first accommodation cavity and a second accommodation cavity spaced apart from each other. The main control module 31 is disposed in the first accommodation cavity. The drive module 32 is disposed in the second accommodation cavity. The drive module 32 is electrically connected to the main control module 31, and the drive module 32 is electrically connected to the blower 21. That is, the drive module 32 and the main control module 31 are respectively disposed in the first accommodation cavity and the second accommodation cavity of the electric control chamber 102. The drive module 32 and the main control module 31 may be arranged separately. In this way, the stability of operation is improved. A vent 110 is formed at the wall of the electric control chamber 102, and the vent hole 110 is in communication with an outer space and an inner space of the electric control chamber 102. Further, the vent 110 is in communication with the outer space of the electric control chamber 102 and the second accommodation cavity to allow the air in the second accommodation cavity to exchange heat with the outer space of the electric control chamber 102. In this way, the temperature of the second accommodation cavity can be easily lowered.

In at least one embodiment of the present disclosure, the drive module 13 and the main control module 31 are separate members. That is, the drive module 13 and the main control module 31 are arranged separately in the electric control chamber 102. The drive module 13 is electrically connected to the main control module 31. The drive module 13 is electrically connected to the electric motor 22. The electric motor 22 is in transmission connection with the blower 21. That is, based on a shape and a structure of the air conditioner indoor unit 100 or the housing 10, the main control module 31 and the drive module 13 may be connected to one side wall or two opposite side walls of the electric control chamber 102. It is also possible for the main control module 31 and the drive module 13 to be respectively connected to adjacent side walls of the electric control chamber 102. In this way, connection and management and space arrangement can be facilitated, thereby reducing a volume of the housing 10.

Referring to FIG. 1 and FIG. 2, in at least one embodiment of the present disclosure, the air conditioner indoor unit 100 further includes a radiator 33 connected to the main control module 31. By providing the radiator 33, rapid heat dissipation and cooling of the inner space of the electric control chamber 102 can be carried out, thereby effectively maintaining the operating environment of the electric control board and the drive module. The heat exchange may be carried out on ambient air inside the electric control chamber 102 to cool the electric control chamber 102, thereby improving the heat dissipation effect and operational stability of the electric control chamber 102. The radiator 33 may be disposed inside the electric control chamber 102, or the radiator 33 may be at least partially disposed outside the electric control chamber 102. That is, a part of the radiator 33 may be disposed inside the electric control chamber 102, and another part of the radiator 33 may be disposed outside the electric control chamber 102. In this way, the radiator 33 can remove heat from the electric control chamber 102, thereby lowering the temperature in the electric control chamber 102.

In at least one embodiment of the present disclosure, a temperature sensor for detecting a temperature may be disposed in the electric control chamber 102. When the electric control chamber 102 has a high temperature, the temperature sensor can give a prompt, thereby improving the operation safety of the air conditioner indoor unit 100. It is also possible to connect the temperature sensor to at least one of the drive module 32 and the radiator 33 or position the temperature sensor close to the drive module 32 to detect the temperature of the drive module 32, thereby rationally controlling the radiator 33. Therefore, the heat dissipation effect can be improved, thereby facilitating the energy saving.

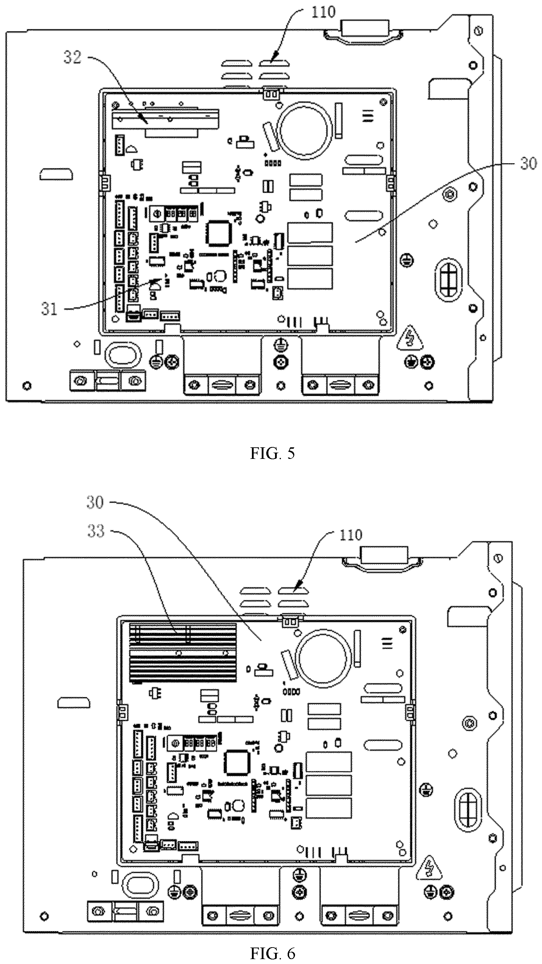

With reference to FIG. 2 and FIG. 6, in at least one embodiment of the present disclosure, the drive module 32 is arranged horizontally. The drive chip 321 of the drive module 32 is disposed at an upper part of the drive module 32. The radiator 33 is disposed above the drive chip 321 and covers the drive chip 321. In an exemplary embodiment, since the air conditioner indoor unit 100 is typically arranged vertically and the drive module 32 is arranged horizontally, it is possible to make full use of the space of the air conditioner indoor unit 100 in the horizontal direction thereof, which is advantageous in reducing the volume of the air conditioner indoor unit 100. Further, the drive chip 321 is disposed at the upper part of the drive module 32. In this way, one the one hand, the drive chip 321 can face towards the radiator 33, and on the other hand, the radiator 33 can be positioned above the drive chip 321. As a result, the heat dissipation effect of the radiator 33 on the drive chip 321 can be improved. Also, the radiator 33 can also shield the drive chip 321 to avoid dust from being accumulated at the drive chip 321, thereby improving the dust-proof function and avoiding the operation of the chip from being affected. Moreover, space arrangement can be facilitated.

With reference to FIG. 3, in at least one embodiment of the present disclosure, the radiator 33 can completely cover the drive chip 321 of the drive module 32, facilitating rapid cooling of the drive chip 321 by the radiator 33. Further, a peripheral edge of the radiator 33 extends beyond the drive chip 321, and an air gap is formed between the peripheral edge of the radiator 33 and the drive module 32. In this way, the air gap between the peripheral edge of the radiator 33 and the drive module can form an air channel, through which the air flows. Therefore, the heat dissipation effect can be enhanced, and the heat exchange area of the radiator 33 can be also increased.

Referring to FIG. 3, in the air conditioner indoor unit 100 according to at least one embodiment of the present disclosure, the radiator 33 is mounted in such a manner that the radiator 33 is spaced apart from the drive module 32 and the drive chip 321 is interposed between the radiator 33 and the drive module 32. Further, the heat dissipation airflow passes through the space between the radiator 33 and the drive module 32. Therefore, the heat dissipation effect can be enhanced. The drive module 32 has a plate-like shape extending horizontally. A connector 322 is disposed at the drive module 32. One end of the connector 322 is connected to the drive chip 321, and the other end of the connector 322 penetrates the drive module 32 to support the drive chip 321 above the drive module 32. The radiator 33 includes a main body 331 and a plurality of fins 331. The plurality of fins 332 is connected to the main body 331. Further, the plurality of fins 332 is arranged at interval horizontally and extends vertically. The plurality of fins 332 can rapidly dissipate heat of the main body 331. When the blower 21 is operated, the airflow is driven to flow through the radiator 33, and the airflow exchanges heat with the radiator 33 to improve the heat dissipation effect. In an exemplary embodiment, the airflow direction may be parallel to an extending direction of the fins 332, which can enhance the heat dissipation effect. The airflow can flow through a gap between two fins 332, thereby removing the heat of the fins 332. Therefore, the heat dissipation effect of the radiator 33 is facilitated. In use, the drive chip 321 is in contact with the main body 331, or the drive chip 321 faces towards the body portion 331. The heat of the drive chip 321 can be transferred to the plurality of fins 332 through the main body 331 to dissipate the heat of the drive chip 321.

In conjunction with FIG. 1 and FIG. 3, the horizontal direction may be an up-down direction, the vertical direction may be a left-right direction, and the present disclosure is not limited in this regard.

Referring to FIG. 2, in at least one embodiment of the present disclosure, the air conditioner indoor unit 100 further includes an insulation support 34. In an exemplary embodiment, the radiator 33 is spaced apart from the main control module 31, and the insulation support 34 is connected to the main control module 31 and the radiator 33, respectively. The insulation support 34 can support the radiator 33 at the main control module 31. Therefore, the structural stability can be improved, and it is possible to avoid the radiator 33 from being directly connected to the main control module 31, thereby realizing insulation effect. In addition, the main control module 31 is spaced apart from the radiator 33 by the insulation support 34. As a result, a gap may be formed between the main control module 31 and the insulation support 34. When the air is blown through the gap, the heat can be removed, thereby enhancing the heat dissipation effect.

In at least one embodiment of the present disclosure, a vent 110 is formed at a wall of the electric control chamber 102. The outer space and the inner space of the electric control chamber 102 are in communication with each other through the vent 110 to facilitate the circulation of the air flow in the electric control chamber 102. The vent 110 faces towards the radiator 33 to dissipate heat of the radiator 33, thereby enhancing the heat dissipation effect. In the embodiment, the vent 110 may be formed at each wall of the electric control chamber 102. For example, the vent 110 may be formed at a side wall of the electric control chamber 102 facing towards the air supply duct 101, and is in communication with the air supply duct 101. The vent 110 may be formed at a side wall of the electric control chamber 102 facing away from the air supply duct 101, and is in communication with the outer space of the electric control chamber 102. The vent 110 may also be formed at a side of the electric control chamber 102 facing towards an air outlet of the air supply duct 101. The vent 110 may also be formed at a side of the electric control chamber 102 facing towards an air inlet of the air supply duct 101. The vent 110 may also be formed at top and bottom walls of the electric control chamber 102.

A plurality of vents 110 may be formed at the electric control chamber 102 to construct an airflow channel in the electric control chamber 102 by the plurality of vents 110.

In at least one embodiment of the present disclosure, the electric control chamber 102 has a positioning edge on an inner side surface of the electric control chamber 102. The positioning edge defines a positioning recess at the inner side surface of the electric control chamber 102. The main control module 31 is disposed in the positioning recess. The positioning edge is provided with a plurality of positioning hooks. The plurality of positioning hooks is configured to prevent the main control module 31 from moving out of the electric control chamber 102. At least one of the plurality of positioning hooks is constructed as an elastic hook. When mounting the main control module 31, the elastic hook is deformed to mount the main control module 31 into the positioning recess.

In at least one embodiment of the present disclosure, the radiator 33 is connected to the drive module 32 and configured to exchange heat with the drive module 32. In this way, heat dissipation of the drive module 32 can be realized. Therefore, the heat dissipation effect can be improved, and stable operation of the drive module 32 is facilitated. In addition, overheating of the drive module 32 can be avoided, thereby prolonging the service life thereof.

In other embodiments of the present disclosure, a first vent and a second vent may be formed at the wall of the electric control chamber 102. The inner space and the outer space of the electric control chamber 102 are in communication with each other through the first vent and the second vent. The vent 110 can dissipate heat of the radiator 33. As a result, the heat dissipation effect can be enhanced. The air conditioner indoor unit 100 also includes a cooling fan adapted to drive the airflow in the electric control chamber 102 to flow from the first vent to the second vent. That is, the cooling fan can speed up the airflow circulation in the electric control chamber 102, facilitate improving the heat exchange effect in the electric control chamber 102. Further, heat dissipation of the components in the electric control chamber 102 is facilitated.

Referring to FIG. 1, in at least one embodiment of the present disclosure, the air conditioner indoor unit 100 further includes an electric control box 11 disposed in the housing 10. The electric control box 11 defines the electric control chamber 102. In an exemplary embodiment, the electric control box 11 has a dustproof function, and thus can protect components inside the electric control chamber 102. In an exemplary embodiment, the electric control box 11 may be disposed at a side of the housing 10 to allow for easy space arrangement and easy maintenance and repair. The electric control box 11 may have a main body and a cover body. The main body and the cover body are removably connected to each other. The cover body may cover the main body to protect the components in the electric control chamber. When it is necessary to repair or replace the electric control chamber 102 and the main control module 12 or the drive module 32 inside the electric control chamber 102, the cover is opened. Therefore, the maintenance and replacement of the main control module 31 or the drive module 32 in the electric control chamber 102 are facilitated, thereby improving the maintenance efficiency and reducing the maintenance cost. Also, since the electric control chamber 102 is externally mounted, the inner space of the housing 10 can be saved. In this way, a volume of the housing 10 can be reduced, thereby lowing the cost of the housing 10.

In the present disclosure, the drive module is disposed in the electric control chamber 102, and the drive module 32 is disposed separately from the electric motor 22. Therefore, a flexible design of the drive module 32 is facilitated. For example, the circuits and interfaces on the drive module 32 may be flexibly designed to optimize the functions of the drive module 32. During use, the user may more conveniently repair and modify the drive module 32.

By arranging the drive module 32 in the electric control chamber 102, the assembly and maintenance are facilitated. During the overhaul of the drive module 32, it is not necessary to disassemble the blower 21 of the blower assembly 20, thereby improving the efficiency of maintenance and avoiding damage occurring during the overhaul. Further, the drive module 32 may also be easily upgraded to meet the increasing functional demands on the air conditioner indoor unit. By arranging the drive module 32 in the electric control chamber 102, it is also possible to prevent the space in the air supply duct 101 from being affected due to the electrical motor 22 with too large volume when the drive module 32 is disposed in the electrical motor 22. Further, it is also possible to prevent the space in the air supply duct 101 from being occupied when the drive module 32 is disposed in the air supply duct 101, thereby increasing the air supply volume of the air supply duct 101.

Further, by arranging the drive module 32 in the electric control chamber 102, the remaining space in the electric control chamber 102 can be fully utilized. For example, since there are relatively bulky components such as capacitors and relatively small components such as resistors in the main control module 31 of the electric control chamber 102, after assembling these components together, more space is left in the electric control chamber 102.

It can be seen that in the present disclosure, arranging the drive module 32 in the electric control chamber 102 would not affect other structures in the air conditioner indoor unit, and would not increase the space requirement for the electric control chamber 102. Therefore, the air conditioner indoor unit according to the embodiments of the present disclosure may be applied to existing air conditioner indoor units, thereby reducing cost of the mold. In addition, the upgrade, expansion, and the like of the drive module 32 can be conveniently implemented. Only the drive module 32 is required to be replaced when the function of the drive module 32 or the electrical motor 22 is required to be changed or added. During the manufacturing, the assembly, and the maintenance of the air conditioner indoor unit, it is possible to complete the update and change of the drive module 32 without modifying the whole structure of the air conditioner indoor unit 100, which will not change the assembly process and mold structure. As a result, costs can be reduced, and the modularization design of the air conditioner indoor unit is optimized. For example, for an air conditioner indoor unit with a constant air supply volume function and an air conditioner indoor unit without the constant air supply volume function, only the drive module 32 is replaced without changing the manufacturing steps of the air conditioner indoor unit.

In the air conditioner indoor unit 100 according to the present disclosure, by connecting the drive module 32 and the main control module 31, with reasonable layout, one the one hand, the space can be saved, and one the other hand, a better heat dissipation effect can be achieved. Further, the drive module 32 and the main control module 31 are mounted and fixed by means of a specific structure. As a result, the overall structure is stable and reliable.

In one aspect of the present disclosure, with reference to Figs. 4 and 5, an air conditioner indoor unit 100 is provided. The air conditioner indoor unit 100 includes a housing 10 and a blower assembly 20.

The housing 10 has an air supply duct 101. In an exemplary embodiment, the air supply duct 101 has an air return inlet and an air supply outlet. During an operation of the air conditioner indoor unit 100, an airflow is delivered to an indoor environment along the air supply duct 101. The housing 10 also has an electric control chamber 102, and a main control module 31 is disposed in the electric control chamber 102. A blower assembly 20 includes an electric motor 22, a blower 21, and a drive module 32. The blower 21 is disposed in the air supply duct 101 and configured to drive the airflow. The electric motor 22 is in transmission connection with the blower 21. The drive module 32 is electrically connected with the electric motor 22. The drive module 32 is configured to drive the electric motor 22 to operate, which in turn drives the blower 21. The drive module 32 is disposed in the electric control chamber 102, and the drive module 32 and the main control module 31 are integrated at one circuit board 30.

The drive module 32 and the main control module 31 are both disposed in the electric control chamber 102. As a result, the number of structural components can be reduced. Further, by arranging the two modules in one electric control chamber 102, a distance between the drive module 32 and the main control module 31 is shorter, and thus the signal transmission distance is shorter and the transmission speed is faster. In this way, an outflowing air volume of the air conditioner indoor unit 100 can be adjusted more quickly, and thus the air conditioner indoor unit 100 has a constant air supply volume. Since the electric control chamber 102 is disposed at an end of the air return inlet of the air conditioner indoor unit 100, the drive module 32 may be arranged at the end of the air return inlet of the air conditioner indoor unit 100. As a result, the returned airflow can pass through the drive module 32, thereby improving the heat dissipation efficiency on the drive module 32 and enhancing the heat dissipation effect. In addition, when the two modules are disposed in one electric control chamber 102, assembly efficiency of the air conditioner indoor unit 100 is higher during the assembly. Therefore, the manufacturing cost can be at least partially lowered, and the later maintenance and overhaul are also facilitated.

In the air conditioner indoor unit 100 of at least one embodiment of the present disclosure, by integrating the drive module 32 and the main control module 31 at one circuit board 30, the operation efficiency of the control module can be improved. In addition, rapid and stable control on the blower 21 can be realized, thereby satisfying more operation demands on the blower 21. A rotation speed may be rapidly adjusted based on control instructions to achieve the constant air supply. In addition, the assembly and maintenance efficiency of the air conditioner indoor unit 100 can be improved.

According to at least one embodiment of the present disclosure, the electric control chamber 102 may be spaced apart from the air supply duct 101. For example, the electric control chamber 102 may be spaced apart from the air supply duct 101 by providing a beam in the housing 10. In addition, when the electric control chamber 102 is spaced apart from the air supply duct 101, a vent 110 may also be formed between the electric control chamber 102 and the air supply duct 101 for a communication therebetween. In this case, air can be driven by the blower 21 to circulate in the electric control chamber 102, thereby achieving the heat dissipation.

According to at least one embodiment of the present disclosure, the electric control chamber 102 has vents 110. A heat exchange channel is defined between the vents 110 in the electric control chamber 102. In an exemplary embodiment, a vent 110 may be formed at the electric control chamber 102, and the heat exchange channel is defined in the electric control chamber 102. As a result, the airflow can flow into or out of the electric control chamber 102, thereby lower a temperature in the electric control chamber 102. It should be noted that the number of vents 110 at the electric control chamber 102 is not particularly limited. The vents 110 may be formed at several surfaces of the electric control chamber 102 to increase the volume of the air flowing into an interior of the electric control chamber 102, thereby enhancing the heat dissipation effect.

In at least one embodiment of the present disclosure, in order to further enhance the heat dissipation and temperature reduction effect of the vents 110 on the drive module 32, at least one vent 110 is closer to the drive module 32 than the main control module 31. Thus, the airflow can quickly reach the drive module 32 through the vent 110 and quickly dissipate the heat of the drive module 32. In other embodiments, the air flowing through the drive module 32 may flow out of the electric control chamber 102 quickly through the vent 110 to remove heat of the drive module 32, thereby realizing rapid heat dissipation.

According to at least one embodiment of the present disclosure, a dustproof net and/or a drying layer may also be provided at the vent 110. By means of the dustproof net and the drying layer, the airflow can be dried and cleaned, and thus the electric control chamber 102 is kept clean as much as possible to avoid the influence of dust on the components.

According to at least one embodiment of the present disclosure, with reference to FIG. 5, the drive module 32 may be disposed at a corner of the circuit board 30 to further reduce the impact of the drive module 32 on other components within the electric control chamber 102. Thus, it is possible to avoid the influence of the high temperature during the operation of the drive module 32 on other components as much as possible. Meanwhile, it is not necessary to change the initial arrangement of other components in the electric control chamber 102, thereby reducing the manufacturing cost.

According to at least one embodiment of the present disclosure, high heating elements of the main control module 31 and the drive module 32 are disposed at one side of the circuit board 30. Low heating elements of the main control module 31 and the drive module 32 are disposed at another side of the circuit board 30. Thus, a heat transfer between the high heating element and the low heating element is minimized to avoid the influence of the temperature on the operation of the elements. In addition, by providing the high heating elements at one side of the circuit board 30, simultaneous heat dissipation of the high heating elements is facilitated, thereby effectively improving the efficiency and effect of heat dissipation. In addition, since the airflow may be uneven at both sides of the assembled circuit board 30, the heat dissipation effect can be improved by arranging the high heating elements at one side of the circuit board 30.

It should also be noted that by arranging the low heating elements at one side of the circuit board 30, interference of the high heating elements on the low heating elements can be avoided, thereby maintaining the operation environment of the circuit board 30.

The high heating element refers to an electronic component having a large heat generating amount during the operation, such as a drive chip. The low heating element refers to an electronic component having a small heat generating amount during the operation, such as a resistor, a capacitor, whose heat generation amount is relatively low during operation. The high heating element is defined relative to the low heating element, and may be defined as desired.

According to at least one embodiment of the present disclosure, referring to FIG. 4 and FIG. 6, since the air conditioner requires to control the rotational speed of the blower 21 by the drive module 32, the greater a frequency of the drive module 32, the higher the temperature. Therefore, the air conditioner indoor unit 100 may further include a radiator 33. The radiator 33 is connected to the circuit board 30, and disposed inside the electric control chamber 102 or at least partially disposed outside the electric control chamber 102. That is, the radiator 33 may be partially disposed inside the electric control chamber 102 and may partially extend out of the electric control chamber 102 and be disposed outside the electric control chamber 102. As a result, heat can be transferred to the outer space of the electric control chamber 102 while cooling the interior of the electric control chamber 102 by the radiator 33. As a result, loss of heat of the radiator 33 can be accelerate, thereby keeping a normal operation of the electronic control device 1300 to avoid an excessive temperature of the radiator 33. Since the radiator 33 is cooled in time, the cooling efficiency of the radiator 33 on the drive module 32 can be improved, thereby improving the heat dissipation effect.

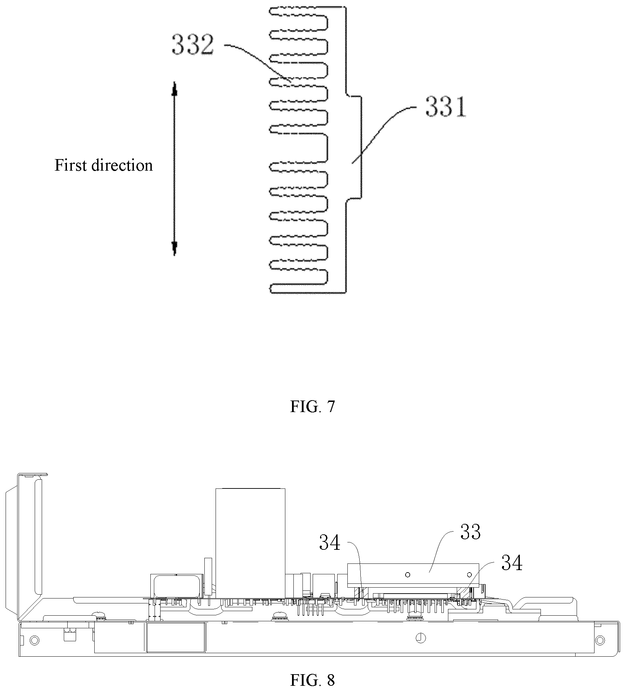

According to at least one embodiment of the present disclosure, referring to FIG. 7, the radiator 33 may be a fin radiator 33. The fin radiator 3 has high metal thermal intensity and heat dissipation efficiency relative to a conventional cast iron radiator 33, and thus has a wide applicability, a high pressure bearing capacity, and a small volume. Therefore, the fin radiator 3 is more suitable for the internal mounting of the air conditioner indoor unit 100, thereby improving compactness of the internal structure.

According to the air conditioner indoor unit 100 of at least one embodiment of the present disclosure, referring to FIG. 7, the radiator 33 may include a main body 331 and a plurality of fins 332. The plurality of fins 332 is connected to the main body 331 and arranged at intervals in a first direction. The plurality of fins 332 extends in a second direction (referring to a direction perpendicular to the page in FIG. 7) perpendicular to the first direction. The plurality of fins 332 can rapidly dissipate heat of the main body 331. When the blower 21 is operated, the airflow is driven to flow through the radiator 33, and the airflow exchanges heat with the radiator 33 to improve the heat dissipation effect. In an exemplary embodiment, the airflow direction may be parallel to an extending direction of the fins 332, which can enhance the heat dissipation effect. The airflow can flow through a gap between two fins 332, thereby removing the heat of the fins 332. Therefore, the heat dissipation effect of the radiator 33 is facilitated. In use, the electric control chamber 102 and/or the drive module 32 face towards the body portion 331. Therefore, the heat can be transferred to the plurality of fins 332 through the main body 331, thereby improving the heat dissipate effect.

According to at least one embodiment of the present disclosure, referring to FIG. 8, the radiator 33 is spaced apart from the circuit board 30. The air conditioner indoor unit 100 may further include an insulation supports 34. The insulation supports 34 is connected to the circuit board 30 and the radiator 33, respectively. In an exemplary embodiment, a plastic piece may be disposed between the radiator 33 and the circuit board 30. The plastic piece may, one the one hand, support the radiator 33, and on the other hand, have an insulation effect for avoiding a short circuit between the radiator 33 and the circuit board 30.

According to at least one embodiment of the present disclosure, with reference to FIG. 4, the radiator 33 may also be disposed within the electric control chamber 102. The electric control chamber 102 has a vent 110 formed at the inner wall of the electric control chamber 102. The vent 110 faces towards a gap between the fins 332 of the radiator 33. Thus, when the airflow flows into the electric control chamber 102 through the vent 110, the airflow may flow through the gap between the fins 332 of the radiator 33, or the airflow may flow through the gap between the fins 332 of the radiator 33 and then flow out through the vent 110. In this way, a contact area between the fins 332 of the radiator 33 and the airflow can be greatly increased, thereby prolonging a contact duration between the air flow and the fins 332. Therefore, the heat dissipation effect of the radiator 33 can be further improved.

According to at least one embodiment of the present disclosure, the radiator 33 at least partially extends out of the electric control chamber 102 towards the air supply duct 101 (referring to the leftward direction in FIG. 4) and extends into the air supply duct 101; or the radiator 33 at least partially extends out of the electric control chamber 102 towards a side of the air supply duct 101. That is, a first opening may be formed at a side of the electric control chamber 102 close to the air supply duct 101. The radiator 33 may partially extend out of the electric control chamber 102 through the first opening and extend into the air supply duct 101. In another embodiment, a second opening may be formed at a side of the electric control chamber 102 facing away from the air supply duct 101. The radiator 33 may partially extend out of the electric control chamber 102 through the second away from the air supply duct 101. Thus, the cooling and heat exchange of the radiator 33 may be carried out by means of the air supply duct 101 to quick dissipate the heat of the radiator 33. Therefore, the cooling effect of the radiator 33 on the drive module 32 is improved to maintain the normal operation of the electric control device 1300. Meanwhile, an airflow with too low a temperature can be blocked from passing through the radiator 33, thereby avoiding condensation.

According to at least one embodiment of the present disclosure, the radiator 33 may be parallel or perpendicular to the circuit board 30, or an angle formed between the radiator 33 and the circuit board 30 is smaller than than 90°. Thus, the heat dissipation effect is improved. In addition, the arrangement of the radiator 33 may be determined based on the arrangement pattern of the vents 110 on the electric control chamber 102, to allow the radiator 33 to be adapted to the ventilation condition, thereby improving the heat dissipation effect.

In some embodiments of the present disclosure, a temperature sensor (not shown) for detecting a temperature may be disposed in the electric control chamber 102. When the electric control chamber 102 has a high temperature, the temperature sensor can give a prompt, thereby improving the operation safety of the air conditioner indoor unit 100. It is also possible to connect the temperature sensor to at least one of the drive module 32 and the radiator 33 or position the temperature sensor close to the drive module 32 to detect the temperature of the drive module 32, thereby rationally controlling the radiator 33. Therefore, the heat dissipation effect can be improved, thereby facilitating the energy saving.

In some embodiments of the present disclosure, the electric control chamber 102 is disposed at an end of the air conditioner indoor unit 100. The air return inlet is formed at a side of the housing 10. That is, the electric control chamber 102 corresponds to the air return inlet. As a result, the returned airflow volume at the electric control chamber 102 is greater. The drive module 32 may include electronic components such as an intelligent power module and a micro-control unit integrated circuit, to drive the blower 21 to operate. In an exemplary embodiment, one, two or more blowers 21 may be driven to rotate. When the air conditioner indoor unit 100 includes a plurality of blowers 21, the plurality of blowers 21 are distributed in a length direction (refer to the left-right direction in FIG. 1) of the air conditioner indoor unit 100.

In some embodiments of the present disclosure, the electric control chamber 102 has a positioning edge on an inner side surface of the electric control chamber 102. The positioning edge defines a positioning recess at the inner side surface of the electric control chamber 102. The main control module 31 is disposed in the positioning recess. The positioning edge is provided with a plurality of positioning hooks. The plurality of positioning hooks is configured to prevent the main control module 31 from moving out of the electric control chamber 102. At least one of the plurality of positioning hooks is constructed as an elastic hook. When mounting the main control module 31, the elastic hook is deformed to mount the main control module 31 into the positioning recess.

In some embodiments of the present disclosure, the air conditioner indoor unit 100 further includes an electric control box 11 disposed in the housing 10. The electric control box 11 defines the electric control chamber 102. In an exemplary embodiment, the electric control box 11 has a dustproof function, and thus can protect components inside the electric control chamber 102. In addition, the electric control box 11 may be disposed at a side of the housing 10 to allow for easy space arrangement and easy maintenance and repair. The electric control box 11 may have a main body and a cover body. The main body and the cover body are removably connected to each other. The cover body may cover the main body to protect the components in the electric control chamber. When it is necessary to repair or replace the electric control chamber 102 and the main control module 12 or the drive module 32 inside the electric control chamber 102, the cover is opened. Therefore, the maintenance and replacement of the main control module 31 or the drive module 32 in the electric control chamber 102 are facilitated, thereby improving the maintenance efficiency and reducing the maintenance cost. Also, since the electric control chamber 102 is externally mounted, the inner space of the housing 10 can be saved. In this way, a volume of the housing 10 can be reduced, thereby lowing the cost of the housing 10.

In at least one embodiment of the present disclosure, the electric control chamber 102 is a flat chamber, which facilitates a space arrangement. The main control module 31 is arranged in the electric control chamber 102 horizontally, and the drive module 32 may be arranged in the electric control chamber 102 horizontally or vertically as desired. In an exemplary embodiment, the electric control box 11 may be disposed at a side of the housing 10 for the space arrangement and easy maintenance and repair.

In the embodiment, the structure of the electric control chamber 102 of the present disclosure is not limited. For example, the electric control chamber 102 may include a metal outer shell and a plastic inner shell disposed inside the metal outer shell. In an exemplary embodiment, the inner shell of the electric control chamber 102 may be made of plastic, and has predetermined insulation and flammability. Therefore, the risk of electric leakage due to internal circuit failure can be reduced. The outer shell may be made of metal material, which has predetermined fire resistance and strong resistance to deformation. Therefore, it is possible to avoid the influence of excessive temperature on the external components of the electric control chamber 102 when the internal fire of the electric control chamber 102 occurs. In other embodiments of the present disclosure, the electric control chamber 102 may also be made of a refractory material. The electric control chamber 102 may be manufactured directly through injection-molded with the refractory material or integrally manufactured in other manners. The manufacturing steps are simpler and it is more convenient for manufacturing.

In the present disclosure, the drive module 32 is disposed in the electric control chamber 102, and the drive module 32 is disposed separately from the electric motor 22. Therefore, a flexible design of the drive module 32 is facilitated. For example, the circuits and interfaces on the drive module 32 may be flexibly designed to optimize the functions of the drive module 32. During use, the user may more conveniently repair and modify the drive module 32.

By arranging the drive module 32 in the electric control chamber 102, the assembly and maintenance are facilitated. During the overhaul of the drive module 32, it is not necessary to disassemble the blower assembly 20, thereby improving the efficiency of maintenance and avoiding damage occurring during the overhaul. Further, the drive module 32 may also be easily upgraded to meet the increasing functional demands on the air conditioner indoor unit 100. By arranging the drive module 32 in the electric control chamber 102, it is also possible to prevent the space in the air supply duct 101 from being affected due to the electrical motor 22 with too large volume when the drive module 32 is disposed in the electrical motor 22. Further, it is also possible to prevent the space in the air supply duct 101 from being occupied when the drive module 32 is disposed in the air supply duct 101, thereby increasing the air supply volume of the air supply duct 101.

Further, by arranging the drive module 32 in the electric control chamber 102, the remaining space in the electric control chamber 102 can be fully utilized. For example, since there are relatively bulky components such as capacitors and relatively small components such as resistors in the main control module 31 of the electric control chamber 102, after assembling these components together, more space is left in the electric control chamber 102.

It can be seen that in the present disclosure, arranging the drive module 32 in the electric control chamber 102 would not affect other structures in the air conditioner indoor unit, and would not increase the space requirement for the electric control chamber 102. Therefore, the air conditioner indoor unit according to the embodiments of the present disclosure may be applied to existing air conditioner indoor units 100, thereby reducing cost of the mold. In addition, the upgrade, expansion, and the like of the drive module 32 and the like can be conveniently implemented. Only the drive module 32 is required to be replaced when the function of the drive module or the motor is required to be changed or added. During the manufacturing, the assembly, and the maintenance of the air conditioner indoor unit 100, it is possible to complete the update and change of the drive module 32 without modifying the whole structure of the air conditioner indoor unit 100, which will not change the assembly process and mold structure. As a result, costs can be reduced, and the modularization design of the air conditioner indoor 100 unit is optimized. For example, for an air conditioner indoor unit 100 with a constant air supply volume function and an air conditioner indoor unit 100 without the constant air supply volume function, only the drive module 32 is replaced without changing the manufacturing steps of the air conditioner indoor unit.

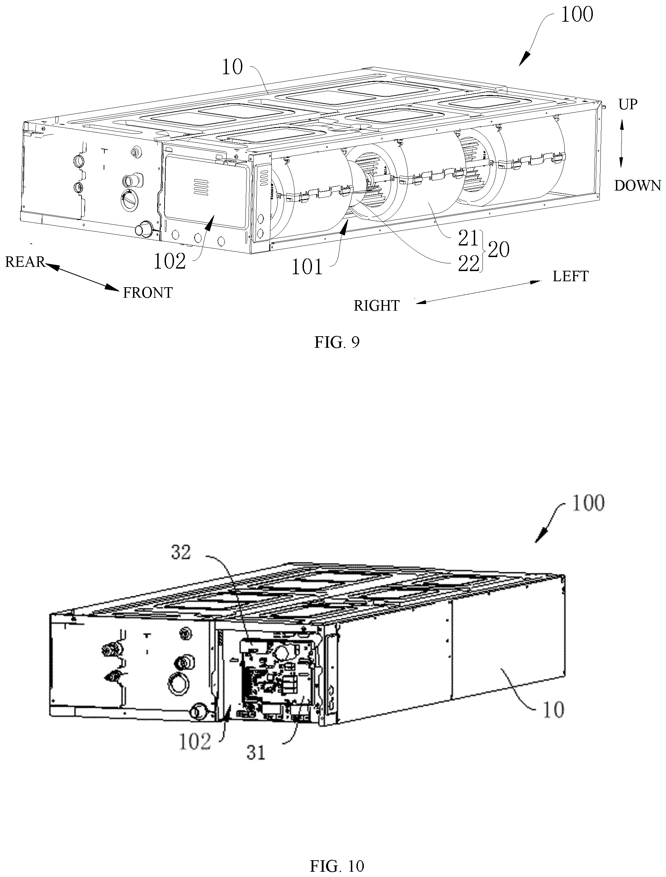

As shown in FIG. 9 to FIG. 11, an air conditioner indoor unit 100 according to at least one embodiment of the present disclosure includes a housing 10, a blower assembly 20, and a drive module 32. The housing 10 may provide an accommodation space and a supporting for the blower assembly 20, the drive module 32, and the like. The blower assembly 20 is configured to drive an airflow to allow the airflow to pass through the air conditioner indoor unit 100, thereby conditioning air. The drive module 32 may provide an energy source and the like for drive the blower assembly 20 to operate.

In an exemplary embodiment, the housing 10 has an air supply duct 101 provided therein. The air supply duct 101 may have an air return inlet and an air supply outlet. The airflow may enter the air supply duct 101 through the air return inlet and be supplied through the air supply outlet after being treated in the air supply duct 101. The blower assembly 20 is disposed in the air supply duct 101 to drive the airflow. The blower assembly 20 can drive the airflow from the air return inlet to the air supply outlet in the air supply duct 101 (supplying the airflow from the front to the rear shown in FIG. 9), then drive the airflow outside the housing 10 to enter the air supply duct 101 through the air return inlet, and then drive the airflow inside the housing 10 to be supplied through the air supply outlet. The drive module 32 is disposed in the housing 10. The drive module 32 may provide a drive signal or the like to the blower assembly 20 to operate blower assembly.

The drive module 32 includes a drive board 111 and a cover 112. The drive board 111 is electrically connected to the blower assembly 20 to drive the blower assembly 20 to operate. The cover body 112 is disposed outside the drive board 111 and covers the drive board 111. The cover body 112 can provide protection for the drive board 111, thereby reducing damage to the drive board 111.

According to the air conditioner indoor unit 100 of at least one embodiment of the present disclosure, the cover body 112 can provide protection for the drive module 32 from damage caused by other components contacting the drive board 111 during the maintenance, mounting, or the like, thereby improving safety performance of the drive module 32. Further, a structure such as burrs disposed on the drive board 111 may be covered to prevent the failure of the air conditioner indoor unit 100 due to peeling of the burrs on the drive board 111.

By providing the cover body 112, it is possible to provide a predetermined protection for the drive board 111, thereby reducing or avoiding external water, dust, and the like from falling on the drive board 111. Therefore, the operational stability can be improved, and service life of the drive board 111 can be prolonged.

The cover body 112 according to the embodiments of the present disclosure may have a variety of different mounting manners. The cover body 112 may be mounted to the drive board 111, to the radiator 33 as described below, or to a structural member (e.g., a main control panel as described below) to which the drive board 111 is mounted. The present disclosure will be described with respect to the cover body 112 and the drive board 111. However, it is not intended to limit the scope of the present disclosure. In addition, the cover body 112 may be connected to the drive board 111 by means of snap joints, bolted connections, welding, bonding, binding, or the like. In view of this, the present disclosure provides at least one mounting manner for mounting and securing the cover plate.

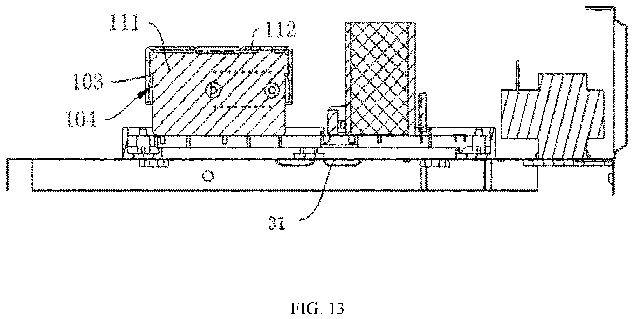

As shown in FIG. 13, in at least one embodiment of the present disclosure, the cover body 112 is provided with a first positioning portion 103. The drive board 111 is provided with a second positioning portion 104. The first positioning portion 103 cooperates with the second positioning portion 104 to limit the cover body 112 from being separated from the drive board 111. By the cooperation between the first positioning portion 103 and the second positioning portion 104, the cover body 112 can be stably mounted on the drive board 111. In this way, the cover body 112 can easily provide increased effective protection for the drive board 111.

As shown in FIG. 13, the cover body 112 has an accommodation recess. The drive board 111 is embedded in the accommodation recess. The first positioning portion 103 is disposed on at least one of two opposite sides of the accommodation recess, and the second positioning portion 104 is disposed on the drive board 111 and corresponds to first positioning portion 103. In this way, the protection of the drive board by the cover body 112 can be achieved. Further, the stability of the cooperation between the drive board 111 and the cover body 112 can also be improved.

In some embodiments of the present disclosure, the first positioning portion 103 is disposed at two opposite sides of the accommodation recess, and the second positioning portion 104 is disposed on the drive board 111 and corresponds to the drive board 111. When an external force is exerted on the cover body 112, the cover body 112 may stably bear the force, thereby further improving the stability of the connection between the cover body 112 and the drive board 111.

In addition, one of the first positioning portion 103 and the second positioning portion 104 includes a positioning hook, and the other one of the first positioning portion 103 and the second positioning portion 104 has a positioning recess. The cover body 112 and the drive board 111 are connected to each other by a snap structure through a cooperation between the positioning hooks and the positioning recess. In this way, the connection structure between the cover body 112 and the drive board 111 is simplified, and the assembly is facilitated.

As shown in FIG. 5, the drive board 111 is provided with a protrusion at an end of the side edge of the drive board 111. A structure of the positioning recess is defined between the protrusion and other parts on the side edge. The positioning hook is disposed on the inner side surface of the accommodation recess. After mounting, the hook is embedded into the positioning recess, thereby achieving the stable mounting of the cover body 112 and the drive board 111. In addition, a wedge-shaped guide structure may be provided on the positioning hook. In this way, during the mounting of the cover body 112, the stable mounting of the cover body 112 and the drive board 111 can be achieved by means of the wedge-shaped structure.

In at least one embodiment of the present disclosure, the cover body 112 has an accommodation recess. The drive board 111 is embedded in the accommodation recess. The accommodation recess has sliding grooves formed on two opposite side surfaces of accommodation recess and allowing the side edge of the drive board 111 to slide into the accommodation recess. During the mounting, the two opposite side edges of the drive board 111 may correspond to the sliding grooves in the accommodation recess, respectively, and slide the cover body 112 to allow the side edges of the drive board 111 to slide along the sliding grooves. In this way, quick mounting of the cover body 112 and the drive board 111 can be implemented.

In connection with at least one of the foregoing embodiments, the stable mounting of the cover body 112 on the drive board 111 can be achieved by positioning the first positioning portion 103 and the second positioning portion 104 when the two opposite sides of the drive board 111 slide into a predetermined position in the slide grooves.

In addition, in the present disclosure, a gap is formed between the cover body 112 and the drive board 111. The cover body 112 has a heat dissipation hole 105 in communication with the gap. By forming the heat dissipation holes 105, it is possible to facilitate a direct contact between a heat dissipation medium and the drive board 111, thereby increasing the heat dissipation area. As a result, a better heat dissipation effect can be provided. In addition, it is possible to avoid the circulation of the heat exchange medium from being affected when the cover plate covers the drive board 111.

In addition, the cover body 112 may have a plurality of heat dissipation holes 105. The plurality of heat dissipation holes 105 is constructed into grid holes. In this way, protection and ventilation effect can be provided for the drive board 111. In addition, the plurality of grid holes constructed by the heat dissipation holes 105 may be disposed on the first plate portion 1121 and cover the first plate portion 1121, to further enhance heat dissipation effect. In other embodiments, the above second plate portion 1122 may also have the heat dissipation holes 105.

In addition, during the operation of the drive module 32, heat dissipation needs to be carried out on the drive module 32. Therefore, the radiator 33 may be connected to the drive board 111, and the heat of the drive board 111 can be dissipated by the radiator 33. During the heat dissipation, the radiator 33 can increase a contact area with the heat dissipation medium, thereby improving the heat dissipation efficiency and effect. In at least one embodiment of the present disclosure, the drive module 32 further includes a radiator 33. The radiator 33 is connected to the drive board 111 and configured to exchange heat with the drive board 111, and the drive board 111 is interposed between the radiator 33 and the cover body 112. The radiator 33 may cooperate with the cover body 112 to protect the drive board 111 while providing heat dissipation for the drive board 111. Further, heat dissipation of the drive board 111 is facilitated while providing protection to the drive board 111. In addition, since the radiator 33 and the cover body 112 are respectively disposed at two opposite sides of the drive board 111, the radiator 33 can be sufficiently brought into contact with the heat dissipation medium such as air, and thus the heat dissipation of the drive board 111 can be prevented from being affected by the additional cover plate.

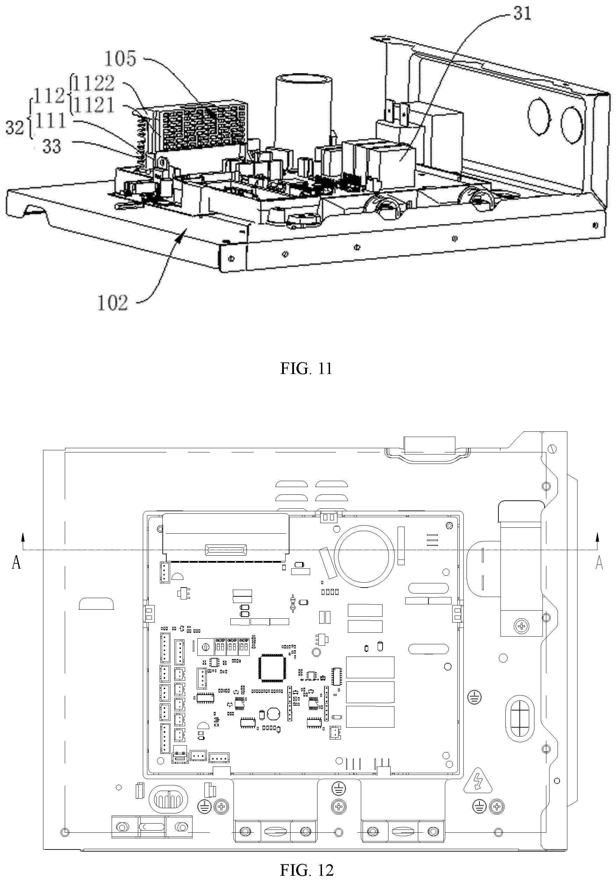

In addition, the cover plate in the present disclosure can isolate the drive board 111 from dust, maintenance equipment, installation equipment, or the like. to provide protection for the drive board 111. In order to further enhance the protection effect on the drive board 111, the cover plate according to the embodiments of the present disclosure can shield a gap (an accommodation space for the drive board 111) between the cover body 112 and the radiator 33, to further enhance the protection effect. As shown in FIG. 11, the cover body 112 includes a first plate portion 1121 and a second plate portion 1122. The first plate portion 1121 and the radiator 33 are disposed at two opposite sides of the drive board 111. The second plate portion 1122 is connected to the first plate portion 1121, and covers the radiator 33 and a gap between the radiator 33 and the first plate portion 1121. By assembling the first plate portion 1121 and the radiator 33, the drive board 111 may be protected. The second plate portion 1122 can shield the gap between the first plate portion 1121 and the radiator 33. In this way, the drive board 111 can be completely protected, and thus the protective effect on the drive board 111 can be improved. In addition, the second plate portion 1122 may shield a part of the radiator 33 or the entire radiator 33 to provide protection for the radiator 33.

As shown in FIG. 11, the radiator 33 is connected to the drive board 111 and configured to exchange heat with the drive board 111, and a fin 332 is disposed at a side of the radiator 33 facing away from the drive board 111. By providing the fin 332, it is possible to improve the heat dissipation effect on the drive board 111. In addition, the drive board 111 is interposed between the radiator 33 and the cover body 112. By arranging the fins 33 away from the drive board 111, it is possible allow for more contact space between the fins 33, thereby effectively avoiding the influence of the cover body on the air flow circulation.

In addition, as described above, the cover body 112 may also be mounted at the radiator 33 or other structure. In this case, the cover body 112 may be made of a plastic material to ensure insulation effect of the cover body 112, thereby improving the operation stability of the drive board 111. In other embodiments, the cover body 112 may be made of a metal material or other materials. The heat dissipation effect of the drive board 111 can be optimized when the cover body 112 is made of the metal material.

In at least one embodiment of the present disclosure, the drive board 111 is disposed in the air supply duct 101. In this way, heat dissipation of the drive board 111 can be improved by means of the blower assembly 20. The drive board 111 may be disposed on an air inflowing path or an air outflowing path of the blower assembly 20. The drive board 111 is provided upstream of the radiator 33 in the air supply duct 101 to prevent the radiator 33 from affecting the stable operation of the drive board 111 or generating condensation. Further, the drive board may be disposed at a position away from the side wall of the air supply duct 101. In this way, it is possible to prevent the flowing of the airflow through the drive board 111 from being affected by the side wall of the air supply duct 101.

In at least one embodiment of the present disclosure, the housing 10 also has an electric control chamber 102, and the drive board 111 is disposed in the electric control chamber 102. By arranging the drive board 111 in the electric control chamber 102, maintenance and mounting of the drive board 111 are facilitated.

In addition, the electric control chamber 102 and the air supply duct 101 may be spaced apart from each other. When the electric control chamber 102 is spaced apart from the air supply duct 101, the electric control chamber 102 is not completely isolated from the air supply duct 101. A vent may also be formed between the electric control chamber 102 and the air supply duct 101 for communication. As a result, air can be driven by the blower 21 to circulate in the electric control chamber 102, thereby achieving heat dissipation. In other embodiments, the electric control chamber 102 may be completely isolated from the air supply duct 101.

The blower assembly 20 according to the present disclosure may include a blower 21 and an electric motor 22. The blower 21 is disposed in the air supply duct 101 to drive the airflow. The electric motor 22 is in transmission connection with the blower 21 to drive the blower 21 by the electric motor 22, thereby driving the airflow. The drive module 32 is electrically connected to the electric motor 22. The drive module 32 can drive the electric motor 22 to operate. Further, the blower 21 can drive the airflow to flow through the heat exchanger for the heat dissipation.

In some embodiments of the present disclosure, the electric control chamber 102 may also be provided with a main control module 31, and the drive board 111 is mounted at the main control module 31.

In some embodiments of the present disclosure, the electric control chamber 102 has a positioning edge on an inner side surface of the electric control chamber 102. The positioning edge defines a positioning recess at the inner side surface of the electric control chamber 102. The main control module 31 is disposed in the positioning recess. The positioning edge is provided with a plurality of positioning hooks. The plurality of positioning hooks is configured to prevent the main control module 31 from moving out of the electric control chamber 102. At least one of the plurality of positioning hooks is constructed as an elastic hook. When mounting the main control module 31, the elastic hook is deformed to mount the main control module 31 into the positioning recess.

The drive module 32 and the main control module 31 may be integrated at one circuit board. In addition, the main control module 31 and the drive module 32 may be separate members. In this way, the mutual interference between the main control module 31 and the drive module 32 can be reduced. Further, a structure of the main control module 31 and the drive module 32 in the related art may not be modified or less modified, and thus cost of the air conditioner indoor unit 100 can be lowered. The drive module 32 may be mounted at the main control module 31. For example, the drive module 32 is disposed at the main control module 31 vertically. For another example, the drive module 32 and the main control module 31 are parallel to each other. As another example, the drive module 32 is inclined relative to the main control module at a predetermined angle 31. In addition, the drive module 32 is mounted at a corner position of the main control module 31 in other manners.

It is also possible to arrange the drive module 32 and the main control module 31 separately in the electric control chamber 102, and the drive module 32 and the main control module 31 are arranged at different positions in one chamber. For example, the drive module 32 and the main control module 31 may be both disposed at a wall of the electric control chamber 102 horizontally. It is also possible to arrange the main control module 31 at a bottom wall of the electric control chamber 102 horizontally and arrange the drive module 32 at a side wall of the electric control chamber 102 horizontally. The mounting positions and manners of the drive module 32 and the main control module 31 may be selected as desired.

In addition, the drive module 32 and the main control module 31 may be disposed in different cavities within the electric control chamber 102.

According to the air conditioner indoor unit 100 of at least one embodiment of the present disclosure, the drive board 111 is additionally provided with a protective cover. In this way, heat dissipation effect is ensured while achieving strong electricity protection, thereby effectively avoiding mounting collision. A heat dissipation hole 105 is formed at the cover body 112 to ensure the heat dissipation effect. The cover body 112 may be fixed on the drive board 111 by means of a mounting manner such as the sliding groove and the snap. A specific structure is designed on the drive board 111 to cooperate with the mounting of the cover body 112. A sliding groove structure is provided on the cover body 112 to avoid damaging to other components during the mounting. The end of the sliding groove is mounted in a guiding manner to improve the manufacturing and assembly efficiency. When a middle limiting is implemented within the cover body 112, a sufficient mounting space is reserved for the unavoidable burrs of the drive board 111 to avoid interference with the protective cover to damage the protective cover. The drive board 111 may be inserted on the main control module 31 by means of a silver corner. Therefore, it is possible to effectively avoid damaging to the silver corner of the drive module 32 during the mounting.

In the present disclosure, the drive module 32 is disposed in the electric control chamber 102, and the drive module 32 is arranged separately from the electric motor 22. Therefore, a flexible design of the drive module 32 is facilitated. For example, the circuits and interfaces on the drive module 32 may be flexibly designed to optimize the functions of the drive module 32. During use, the user may more conveniently repair and modify the drive module 32.

By arranging the drive module 32 in the electric control chamber 102, the assembly and maintenance are facilitated. During the overhaul of the drive module 32, it is not necessary to disassemble the blower 21 of the blower assembly 20, thereby improving the efficiency of maintenance and avoiding damage occurring during the overhaul. Further, the drive module 32 may also be easily upgraded to meet the increasing functional demands on the air conditioner indoor unit. By arranging the drive module 32 in the electric control chamber 102, it is also possible to prevent the space in the air supply duct 101 from being affected due to the electrical motor 22 with too large volume when the drive module 32 is disposed in the electrical motor 22. Further, it is also possible to prevent the space in the air supply duct 101 from being occupied when the drive module 32 is disposed in the air supply duct 101, thereby increasing the air supply volume of the air supply duct 101.

Further, by arranging the drive module 32 in the electric control chamber 102, the remaining space in the electric control chamber 102 can be fully utilized. For example, since there are relatively bulky components such as capacitors and relatively small components such as resistors in the main control module 31 of the electric control chamber 102, after assembling these components together, more space is left in the electric control chamber 102.

It can be seen that in the present disclosure, arranging the drive module 32 in the electric control chamber 102 would not affect other structures in the air conditioner indoor unit, and would not increase the space requirement for the electric control chamber 102. Therefore, the air conditioner indoor unit according to the embodiments of the present disclosure may be applied to existing air conditioner indoor units, thereby reducing cost of the mold. In addition, the upgrade, expansion, and the like of the drive module can be conveniently implemented. Only the drive module 32 is required to be replaced when the function of the drive module or the electrical motor 22 is required to be changed or added. During the manufacturing, the assembly, and the maintenance of the air conditioner indoor unit 100, it is possible to complete the update and change of the drive module 32 without modifying the whole structure of the air conditioner indoor unit 100, which will not change the assembly process and mold structure. As a result, costs can be reduced, and the modularization design of the air conditioner indoor unit is optimized. For example, for an air conditioner indoor unit with a constant air supply volume function and an air conditioner indoor unit without the constant air supply volume function, only the drive module is replaced without changing the manufacturing steps of the air conditioner indoor unit.

At least one of the embodiment of the present disclosure is described by taking a duct type air conditioner as an example. The technical solution of the present disclosure is not limited to the duct type air conditioner, and may also be applied to an air conditioner indoor unit such as a ceiling-mounted air conditioner and a wall-mounted air conditioner.

In addition, the terms "first" and "second" are used for descriptive purposes only and are not to be construed as indicating or implying relative importance or implicitly indicating the number of technical features indicated. Thus, a feature defined by "first" or "second" may explicitly or implicitly include at least one such feature. In the description herein, "a plurality of" means at least two, e.g., two, three, etc. unless specifically and specifically limited otherwise.

In the present disclosure, unless expressly stated or limited otherwise, the terms "mounted," "connected," "connecting," "fixed" and the like are to be interpreted broadly, e.g., either fixedly or detachably, or integrally modularization. It may be a mechanical connection or an electrical connection. It may be a direct connection or indirect connection by an intermediary. It may be a communication between two elements, or may be in an interactive relationship between two elements, unless explicitly defined otherwise. The specific meaning of the above terms in this application will be understood in specific circumstances by those of ordinary skill in the art.

In the present disclosure, unless expressly stated or limited otherwise, "above" or "below" a first feature on a second feature may mean that the first and second features are in direct contact, or that the first and second features are in indirect contact by an intermediary. Further, the first feature being "on" or "above" the second feature may mean that the first feature is directly above or obliquely above the second feature or merely indicates that the first feature is at a higher level than the second feature. The first feature being "below" or "beneath" the second feature may mean that the first feature is directly below or obliquely below the second feature, or merely indicates that the first feature is at a lower level than the second feature.

In the description, reference to the terms "an embodiment," "example," "a specific example," and "some examples," etc., means that specific features, structures, materials, or characteristics described in connection with the embodiment or example is included in at least one embodiment or example of the application. In the present specification, schematic statement of the above terms do not necessarily refer to the same embodiment or example. Further, the particular features, structures, materials, or characteristics described may be combined in any suitable manner in any one or more embodiments or examples. Furthermore, the incorporations and combinations of the various embodiments or examples and features of the various embodiments or examples described in this description may be made by those skilled in the art without departing from the scope of the invention.

While embodiments of the present disclosure have been shown and described, it will be understood that the above-described embodiments are illustrative and are not to be construed as limiting the present disclosure, and that variations, modifications, substitutions, and alterations in the above-described embodiments may be effected by one of ordinary skill in the art without departing from the scope of the present disclosure.

## Claims

1. An air conditioner indoor unit, comprising:
a housing having an air supply duct and an electric control chamber provided therein, the electric control chamber having a main control module provided therein; and
a blower assembly comprising an electric motor, a blower, and a drive module, the blower being disposed in the air supply duct and configured to drive an airflow, the electric motor being in transmission connection with the blower, and the drive module being electrically connected to the electric motor.

2. The air conditioner indoor unit according to claim 1, wherein:
the drive module is disposed in the electric control chamber;
the main control module and the drive module are separate members; and
the drive module is mounted at the main control module.

3. The air conditioner indoor unit according to claim 2, wherein:
the drive module is disposed at the main control module vertically; or
the drive module and the main control module are parallel to each other; or
the drive module is inclined relative to the main control module at a predetermined angle.

4. The air conditioner indoor unit according to claim 1, wherein:
the drive module is disposed in the electric control chamber; and
the drive module and the main control module are integrated at one circuit board.

5. The air conditioner indoor unit according to claim 4, wherein the electric control chamber has vents.

6. The air conditioner indoor unit according to claim 5, wherein at least one of the vents is closer to the drive module than the main control module.

7. The air conditioner indoor unit according to any one of claims 4 to 6, wherein the drive module is mounted at a corner of the circuit board.

8. The air conditioner indoor unit according to claim 7, wherein the drive module is provided with a radiator at a side of the drive module facing towards an outer side of the main control module.

9. The air conditioner indoor unit according to any one of claims 1 to 8, wherein:
the drive module has a module pin; and
the drive module is connected to the main control module by the module pin.

10. The air conditioner indoor unit according to claim 9, wherein the module pin is provided with a foil.

11. The air conditioner indoor unit according to claim 9, wherein:
the module pin has a step structure;
the module pin has an end inserted on the main control module; and
a step surface of the module pin is supported at the main control module.

12. The air conditioner indoor unit according to claim 4, wherein:
high heating elements in the main control module and the drive module are disposed on one side of the circuit board; and
low heating elements in the main control module and the drive module are disposed on another side of the circuit board.

13. The air conditioner indoor unit according to any one of claims 4 to 8, further comprising a radiator connected to the circuit board,
wherein the radiator is disposed inside the electric control chamber or at least partially disposed outside the electric control chamber.

14. The air conditioner indoor unit according to claim 13, wherein:
the radiator is spaced apart from the circuit board; and
the air conditioner indoor unit further comprises insulation support connected to the circuit board and the radiator, respectively.

15. The air conditioner indoor unit according to claim 13, wherein:
the radiator is disposed in the electric control chamber;
the electric control chamber has a vent formed at a wall of the electric control chamber, the vent facing towards a fin gap of the radiator.

16. The air conditioner indoor unit according to claim 13, wherein:
the drive module is disposed horizontally;
the drive module has a drive chip provided at an upper part of the drive module; and
the radiator is disposed above the drive chip and covers the drive chip.

17. The air conditioner indoor unit according to claim 13, wherein:
the radiator at least partially extends out of the electric control chamber towards the air supply duct and extends into the air supply duct; or
the radiator at least partially extends out of the electric control chamber away from the air supply duct.

18. The air conditioner indoor unit according to claim 13, wherein: the radiator is parallel or perpendicular to the circuit board; or
an angle formed between the radiator and the circuit board is smaller than 90°.

19. The air conditioner indoor unit according to claim 16, wherein:
the radiator completely covers the drive chip of the drive module;
the radiator has a peripheral edge extending beyond the drive chip; and
an air gap is formed between the peripheral edge of the radiator and the drive module.

20. The air conditioner indoor unit according to claim 1, wherein:
the drive module is disposed in the housing; and
the drive module comprises a drive board and a cover body, the drive board being electrically connected to the blower assembly, and the cover body being disposed outside the drive board.

21. The air conditioner indoor unit according to claim 20, wherein:
the cover body is provided with a first positioning portion; and
the drive board is provided with a second positioning portion cooperating with the first positioning portion to restrict the cover body from being disengaged from the drive board.

22. The air conditioner indoor unit according to claim 21, wherein one of the first positioning portion and the second positioning portion comprises a positioning hook, and another one of the first positioning portion and the second positioning portion comprises a positioning recess.

23. The air conditioner indoor unit according to claim 21 or 22, wherein:
the cover body has an accommodation recess;
the drive board is embedded into the accommodation recess;
the first positioning portion is disposed at at least one of two opposite side surfaces of the accommodation recess; and
the second positioning portion is disposed on the drive board and corresponds to the first positioning portion.

24. The air conditioner indoor unit according to any one of claims 20 to 22, wherein:
the cover body has an accommodation recess;
the drive board is embedded into the accommodation recess; and
the accommodation recess has a sliding groove formed at two opposite side surfaces of the accommodation recess and allowing a side edge of the drive board to slid into the accommodation recess.

25. The air conditioner indoor unit according to any one of claims 20 to 22, wherein:
a gap is formed between the cover body and the drive board; and
the cover body has a heat dissipation hole in communication with the gap.

26. The air conditioner indoor unit according to any one of claims 20 to 22, wherein:
the drive module further comprises a radiator connected to the drive board and configured to exchange heat with the drive board; and
the drive board is interposed between the radiator and the cover body.

27. The air conditioner indoor unit according to claim 26, wherein the cover body comprises:
a first plate portion, the first plate portion and the radiator being arranged at two opposite sides of the drive board, respectively; and
a second plate portion connected to the first plate portion and covering the radiator and a gap between the radiator and the first plate portion.

28. The air conditioner indoor unit according to claim 26, wherein:
the radiator is connected to the drive board and is configured to exchange heat with the drive board; and
the radiator is provided with a fin at a side of the radiator facing away from the drive board.

29. The air conditioner indoor unit according to any one of claims 20 to 22, wherein the drive board is disposed in the air supply duct.

30. The air conditioner indoor unit according to any one of claims 20 to 22, wherein:
the housing further has the electric control chamber provided therein; and
the drive board is disposed in the electric control chamber.

31. The air conditioner indoor unit according to claim 30, wherein:
the electric control chamber further has a main control panel provided therein; and
the drive board is mounted at the main control panel.
